# EUROPÄISCHE PATENTANMELDUNG

(11) **EP 0 694 629 A2**
(43) Veröffentlichungstag der Anmeldung: **31.01.1996**
(21) Anmeldenummer: 95111379.4
(22) Anmeldetag: 20.07.1995
(51) Int. Cl.: C23C 8/80, C23C 14/02, C23C 28/00, C23C 16/02

(54) **Korrosions- und verschleissfester Körper, Verfahren zu dessen Herstellung sowie Vakuumbehandlungsanlage**

(30) Priorität: 27.07.1994 EP 94111676
(71) Anmelder: BALZERS SA, F-68390 Sausheim (FR)
(72) Erfinder: Dingremont, N.M., F-68100 Mulhouse (FR); Bergmann, Erich, CH-4058 Basel (CH); Collignon, Pierre, F-77500 Chelles (FR)
(74) Vertreter: Troesch Scheidegger Werner AG

(57) **Zusammenfassung**

Um einen korrosions- und verschleissfesten Körper zu schaffen, welcher, verglichen beispielsweise mit einem martensitischen, rostfreien Stahl, wie X90CrMoV18, vom Grundmaterial her betrachtet, einfacher verarbeitbar und kostengünstiger ist, wird ein Baustahl, wie beispielsweise X45NiCrMo4, oder ein Warmarbeitsstahl erst mit einer thermochemischen Vergütungsschicht, wie beispielsweise einer Nitridschicht, versehen, dann mit einer Hartstoffschicht, wie beispielsweise einer TiN-Schicht. Beispielsweise die Resultate potentiostatischer Messungen ergeben, dass der wie erwähnt beschichtete Bau- oder Warmarbeitsstahl bezüglich Korrosions- und Verschleissfestigkeit ausgezeichnete Eigenschaften aufweist.

## Beschreibung

Die vorliegende Erfindung betrifft einen korrosions- und verschleissfesten Körper nach dem Oberbegriff von Anspruch 1, ein Verfahren zu dessen Herstellung nach demjenigen von Anspruch 4 sowie eine Anlage hierfür nach Anspruch 13.

Für zahlreiche Anwendungen im Maschinen- und Vorrichtungsbau werden Komponenten benötigt, die verschleissfest sein sollten und starken korrosiven Angriffen widerstehen können. Dafür sind folgende Lösungen bekannt:

Die Komponenten werden aus einem ausreichend korrosionsfesten Material gefertigt und nachfolgend mit einer Verschleissschutzschicht versehen. Für einen hochwertigen Verschleissschutz eignen sich nur CVD-, PVD- bzw. PECVD-Verfahren. Als Grundwerkstoff der Komponenten kommen je nach Stärke des korrosiven Angriffs Sonderlegierungsstähle sowie austenitische oder martensitische rostfreie Stähle in Frage. Solche Sonderlegierungsstähle können aber, wenn überhaupt, nur mit erheblichem Aufwand bearbeitet werden und sind deshalb nur bei im wesentlichen kostenunabhängigen Spezialanwendungen denkbar.

Komponenten aus austenitischen rostfreien Stählen sind wegen ihrer schlechten Zerspanbarkeit und wegen des relativ hohen Materialpreises teuer. Hinzu kommt, dass die mechanischen Eigenschaften dieser Werkstoffe für Komponenten, die mechanisch hoch belastet werden, wie für Maschinenelemente, im allgemeinen nicht ausreichend sind.

Die Korrosionsfestigkeit der austenitischen rostfreien Stähle wäre in den meisten Fällen ausreichend.

Martensitische rostfreie Stähle hingegen verlieren ihre Korrosionsfestigkeit, wenn sie über ca. 300°C erhitzt werden. Dies wiederum schliesst den Einsatz gängiger CVD-Verfahren aus und lässt auch bei PVD- und PECVD-Verfahren nur diejenigen zu, die erst bei grossem Aufwand reproduzierbare Beschichtungen liefern. Einer der Gründe dafür, dass im allgemeinen eine Verschleissschutzschicht-Beschichtung bei Temperaturen höher als 300°C erfolgen sollte, ist die ansonsten ungenügende Haftung der Verschleissschutzschicht auf dem Grundmaterial.

Ein zweiter Weg, der zur Lösung des obgenannten Problems begangen wurde, ist die Verwendung von Doppelbeschichtungen. So wurde in der DE-A-38 29 007 für den Formenbau vorgeschlagen, erst mit einem nass-chemischen Verfahren eine Vergütungsschicht aus chemischem Nickel auf die Stahlgrundkörper aufzubringen und darnach eine PVD-Beschichtung mit einer Verschleissschutzschicht vorzusehen. Dieses Vorgehen in dieser Kombination ist nicht nur aufwendig und durch die Verwendung eines umweltschädigenden nass-chemischen Verfahrensschrittes problematisch; es ergeben sich auch bezüglich Kompatibilität der beiden Verfahren Probleme, weil die genaue Beherrschung der nass-chemisch abgeschiedenen Nickelschicht nur schwerlich möglich ist. Hierzu wird auf M. Hans, E. Bergmann, Surface and Coatings Techn. 62 (1993), S. 626, verwiesen.

Auch werden die beiden erwähnten Verfahren, nämlich nass-chemisch und PVD, üblicherweise von verschiedenen Unternehmungen durchgeführt, weil es sich dabei um völlig unterschiedliche Technologien handelt. Dies bringt bezüglich der Logistik derart zu behandelnder Körper bzw. Komponenten zusätzliche Probleme mit sich, welche sich beispielsweise in Terminverzögerungen, Transport- und Lagerproblemen widerspiegeln können.

Aus der EP-0 537 062 sind Körper bzw. Verfahren eingangs genannter Art bekannt. Dabei wird auf dem Grundkörper thermochemisch erst eine Vergütungsschicht hergestellt in einer Reaktivgasatmosphäre, welche mindestens eine der Verbindungen N₂, CH₄, C₃H₈, H₂S enthält. Anschliessend wird durch Karborieren eine Hartstoffschicht abgelegt. Es bildet sich dabei auf dem Grundkörper erst die erwähnte Vergütungsschicht, dann eine Uebergangsschicht und schliesslich die Hartstoffschicht.

Aehnlich ist es aus der EP-A-0 320 706 bekannt, auf dem Grundkörper in einer einzigen Vakuumkammer durch Diffusionshärtung eine Vergütungsschicht herzustellen, nachfolgend eine Zwischen- und Endschicht. Für die Herstellung der Vergütungsschicht durch Diffusionshärtung wird vorgeschlagen, eine Atmosphäre mit Stickstoff, CO₂, oder eine geeignete andere Atmosphäre vorzusehen. Die Zwischenschicht wird aus Chrom, Tantal, Titan oder aus mit Palladium dotiertem Titan gebildet. Schliesslich wird die Hartstoffschicht auf karbidischer, nitridischer, karbonitridischer oder kohlenstoffhaltiger Basis erzeugt.

Bezüglich der Beschichtung von Grundkörpern mit einer Vergütungsschicht und einer Hartstoffschicht kann weiter verwiesen werden auf JP-A-03232957, Patent Abstracts of Japan, Vol. 16, No. 13 (C-0901), wie auch auf JP-A-05098419, Patent Abstracts of Japan, Vol. 17, No. 446 (C-1098), die JP-A-02070074, Patent Abstracts of Japan, Vol. 14, No. 254 (C-0724). Im weiteren wird auch verwiesen auf die JP-A-02122075, Patent Abstracts of Japan, Vol. 14, No. 334 (C-0742).

Gemäss der EP-0 242 100 wird vorgeschlagen, durch Borieren eine Vergütungsschicht als Diffusionsschicht herzustellen, welche darnach mit einer Hartstoffschicht versehen wird.

Bezüglich Herstellung einer thermochemischen Vergütungsschicht kann auch auf die GB-A-2 192 196 verwiesen werden.

Es ist Aufgabe der vorliegenden Erfindung, einen Körper eingangs genannter Art mit bezüglich Verschleissfestigkeit und insbesondere Korrosionsfestigkeit verbesserten Eigenschaften vorzuschlagen und entsprechend ein Verfahren zu dessen Herstellung bzw. eine Anlage hierfür.

Dabei soll die Wahl des verwendeten Grundkörpermaterials, nämlich von Warmarbeits- oder einem Baustahl, aus Gründen der Kostengünstigkeit beibehalten werden und auf dieser Basis die erwähnten Verbesserungen erwirkt werden.

Diese Aufgabe wird am erwähnten Körper durch dessen Ausbildung nach dem kennzeichnenden Teil von Anspruch 1 und/oder 2 erreicht, entsprechend durch ein Verfahren nach dem kennzeichnenden Teil von Anspruch 4 und/oder 5 gekennzeichnet. Eine erfindungsgemässe Anlage zeichnet sich nach dem Wortlaut von Anspruch 13 aus, welche insbesondere die kostengünstige Herstellung des erfindungsgemässen Körpers bzw. die kostengünstige Durchführung des erfindungsgemässen Verfahrens ermöglicht.

Grundsätzlich wurde erkannt, dass die erwähnten Korrosions- und Verschleisseigenschaften an den erwähnten Körpern dadurch wesentlich verbessert werden, dass einerseits eine Abnahme der in der thermochemischen Vergütungsschicht eingebauten erwähnten Elemente gegen die Grenzfläche zur Hartstoffschicht hin verhindert wird, eine Abnahme, wie sie sich üblicherweise durch das Hartstoffbeschichten einstellt, und/oder dass als Verbindung, welche sich im Sinne der erwähnten Eigenschaften für die Vergütungsschicht besonders eignet, Fe₂₋₃N, gegebenenfalls Fe₂₋₃(CN), eingesetzt wird.

Bevorzugte Ausführungsformen des Körpers bzw. des Verfahrens bzw. der Anlage sind in den abhängigen Ansprüchen spezifiziert.

### Definitionen:

- Eine thermochemische Vergütungsschicht ist eine Schicht, welche mit mindestens einer Komponente ihrer Zusammensetzung in oberflächennahe Zonen anderer Materialien eindiffundiert.
- Als "Baustähle" werden bezeichnet die Stähle gemäss "ASM Metals Handbook", Bd. 1, 10. Ausgabe, von ASM International, Kapitel "Hardenable Carbon and Low Alloy Steels", S. 451-570.
- Als "Warmarbeitsstähle" werden bezeichnet Stähle gemäss AISI, Werkzeugstähle der Typen H.

Durch den erfindungsgemässen Körper, dessen Grundmaterial ein Baustahl oder ein Warmarbeitsstahl ist, ist das Körpergrundmaterial kostengünstig und ermöglicht, ebenso kostengünstig, beispielsweise eine spanabhebende Bearbeitung. Es ist erstaunlich, dass durch Versehen des Grundkörpers aus einem dieser Stähle mit einer thermochemischen Vergütungs- und einer Hartstoffschicht ein ausserordentlich korrosions- und verschleissfester Körper entsteht, der entsprechend seiner formgebenden Bearbeitung für zahlreiche Anwendungen im Maschinen- und Vorrichtungsbau eingesetzt werden kann, gegebenenfalls sogar als Werkzeug für die Verarbeitung von organischem Material.

Bekanntlich besteht nämlich die Gefahr, dass bei Aufbringen einer Hartstoffschicht, wie beispielsweise einer TiN-Schicht, auf eine thermochemische Vergütungsschicht mit den erwähnten Elementen in der genannten Diffusionszone eine Verarmung bezüglich des Anteils des erwähnten Elementes entsteht. Diese Verarmung beeinträchtigt das Haftungsverhalten der aufgebrachten Hartstoffschicht. Bei einem erfindungsgemässen Körper ist diese Gefahr weitestgehend behoben.

Es besteht die Hartstoffschicht aus einem Borid, Nitrid, Karbid, Karbonitrid, Nitrokarbid, Oxinitrid, Oxikarbonitrid, Oxinitrokarbid, vorzugsweise eines Metalles der Gruppe IVb oder einer Legierung mit mindestens einem dieser Metalle, besteht aber in der heute bevorzugten Form aus TiN.

Das erfindungsgemässe Verfahren weist insbesondere den Vorteil auf, weil es in derselben Vakuumbehandlungskammer durchgeführt wird, wobei der Uebergang von Vergütungs- in Hartstoffschicht und damit die Haftungsverhältnisse der Hartstoffschicht optimiert werden können.

Im weiteren weist der erfindungsgemässe Körper mit der bevorzugt eingesetzten Nitridvergütungsschicht vorteilhafterweise im wesentlichen kohlenstofffreie ε-Verbindungen in der Form Fe₂₋₃N auf, welche ganz besonders das Korrosionsverhalten des erfindungsgemässen Körpers wesentlich verbessern. Eben gerade durch Vermeiden einer Kohlenstoff-Konzentrationserhöhung in der Vergütungsschicht, und insbesondere bei Vorsehen der mindestens weitgehendst kohlenstofffreien Fe₂₋₃N-Vergütungsschicht, wird eine besonders kompakte und chemisch inerte Schicht gebildet, die zu ausgezeichneter Korrosionsfestigkeit führt.

Die Erfindung wird anschliessend beispielsweise anhand von Figuren und Beispielen erläutert.

Es zeigen:
- Fig. 1: schematisch die Konfiguration einer für das erfindungsgemässe Verfahren erfindungsgemäss eingesetzten Vakuumbehandlungsanlage;
- Fig. 2: die Anlage nach Fig. 1, betreibbar auch zum Heizen und betrieben zum Aufbringen der Vergütungsschicht;
- Fig. 3: die Anlage nach Fig. 1, betrieben zum Aetzen;
- Fig. 4: die Anlage nach Fig. 1, betrieben zum Ionenplattieren;
- Fig. 5 und 6: je ein Schliffbild durch einen erfindungsgemässen Körper mit erfindungsgemäss durch Nitrieren realisierter thermochemischer Vergütungsschicht und aufgebrachter TiN-Hartstoffschicht; Fig. 5: X45NiCrMo4; Fig. 6: X38CrMoV51 (je mit Vergrösserung 1000);
- Fig. 7: die Resultate potentiostatischer Messungen an einem Grundkörper aus dem Baustahl X45NiCrMo4 (a), des mit einer Nitridvergütungsschicht versehenen Körpers aus diesem Baustahl (b), des ausschliesslich mit einer TiN-Hartstoffschicht versehenen Körpers aus diesem Stahl (c) und des erfindungsgemäss sowohl mit einer Nitridvergütungsschicht wie auch einer TiN-Hartstoffschicht versehenen korrosions- und verschleissfesten Körpers aus diesem Stahl (d), nebst den Verläufen des rostfreien, martensitischen Stahls X90CrMoV18;
- Fig. 8: eine Darstellung analog zu derjenigen von Fig. 7 für einen Grundkörper aus dem Warmarbeitsstahl X38CrMoV51.

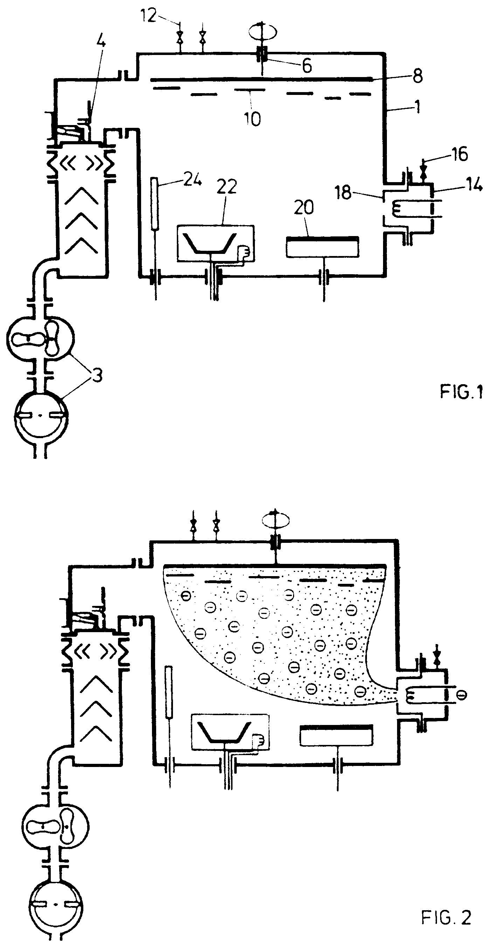

Gemäss Fig. 1 umfasst eine erfindungsgemässe Anlage zur Durchführung des erfindungsgemässen Verfahrens eine Vakuumkammer 1, woran Vakuumpumpen 3 über ein steuerbares Drosselventil 4 angeschlossen sind. An einer Drehdurchführung 6 ist eine Werkstückträgerkalotte 8 vorgesehen, welche auf steuerbare, insbesondere umschaltbare, Bias-Spannung gelegt werden kann. Hinter der Werkstückträgerkalotte 8 mit den schematisch eingetragenen Werkstücken 10 sind Gaseinlässe 12 vorgesehen.

An der Kammer 1 ist weiter eine Heisskathodenkammer 14 mit Gaseinlass 16 vorgesehen. Die Heisskathodenkammer 14 kommuniziert, wie schematisch dargestellt, über eine Blendenanordnung 18 mit dem Innenraum der Kammer 1. Im weiteren kann die Anlage in der Kammer 1 eine Planar-Magnetron-Sputterquelle 20 umfassen, umfasst aber eine Feststoff-Verdampferquelle 22 und eine Hilfsanode 24.

Die Anlage baut auf auf der von der Anmelderin unter der Typenbezeichnung BAI640R eingesetzten und vertriebenen Anlagengrundstruktur.

Die Pumpleistung der Oeldiffusionspumpe und Wälzkolbenpumpe beträgt dabei ca. 800 Liter in der Sekunde.

### Beispiele:

Es wurden 13mm dicke Scheibenproben ab Stangenmaterial geschnitten aus den Stählen gemäss Tabelle 1.

**Tabelle 1**

| Stahlsorte | (A) X45NiCrMo4 Baustahl | (B) X42CrNiMoV14 martensitisch rostfrei | (C) X90CrMoV18 martensitisch rostfrei | (D) X38CrMoV51 Warmarbeitsstahl |
|---|---|---|---|---|
| %C | 0.36 | 0.42 | 0.95-1.2 | 0.38 |
| %Ni | 3.80 | 0.50 | | |
| %Cr | 1.8 | 14.0 | 16-18 | 5.30 |
| %Mo | 0.35 | 0.15 | 0.4-0.8 | 1.30 |
| %V | | 0.1 | | 0.50 |
| %Si | 0.25 | | | 1.00 |
| %Mµ | 0.40 | | | |
| %S | <0.025 | | | |
| %P | <0.030 | | | |
| Zusammensetzung der untersuchten Stähle | | | | |

Anschliessend wurden die Stahlkörper (A) und (D) einer Wärmebehandlung unterzogen. Dies erfolgte in einem bekannten Ofen.

Die Wärmebehandlung, d.h. Wärmebehandlungszeit und -temperatur, ist in Tabelle 2 zusammengestellt.

**Tabelle 2**

| Stahlsorte | | (A) | (D) |
|---|---|---|---|
| Austenisierung | °C | 875 | 1050 |
| | min | 30 | 15 |
| Tempern | °C | 540 | 550 + 595 + 550 |
| | min | 60 | 60 |

Daraufhin wurden diejenigen Körper, welche für einen Salzspraytest vorgesehen waren, geschliffen, die übrigen erst geschliffen, dann poliert.

Alle Körper wurden nun in einer bekannten Waschanlage in alkalischer Lösung, Ultraschall-unterstützt, gereinigt, dann Freon-getrocknet. Nun wurde, als Vergütungsschicht, auf die Körper nach (A) und (D) eine Nitridschicht aufgebracht, wozu die Anlage grundsätzlich gemäss Fig. 2, aber unter Einlass eines Reaktivgases, nämlich von N₂, betrieben wurde. Die Beschichtungsbedingungen für die Vergütungsschicht, im speziellen die hier betrachtete bevorzugte Nitrierungsschicht unter Einlass von N₂, sind in Tabelle 3 zusammengestellt.

**Tabelle 3**

| Stahlsorte | | (A) | (D) |
|---|---|---|---|
| Werkstücktemperatur | [°C] | 570 | 570 |
| Behandlungszeit | [h] | 2 | 2 |
| Temperatur | [°C] | 540 | 570 |
| Entladespannung | [V] | 50 | 52 |
| Entladestrom | [A] | 210 | 230 |
| Gesamtdruck | [Pa] | 0,24 | 0,4 |
| Stickstoff-Partialdruck | [Pa] | 0,12 | 0,28 |
| "Vergütungsschicht" | | | |

Anschliessend wurden die mit der Nitrierungs-Vergütungsschicht versehenen Körper aus den Stählen gemäss (A) und (D) von Tabelle 1 durch Betrieb der Anlage von Fig. 1 nach Fig. 4 durch Ionenplattieren mit einer TiN-Hartstoffschicht beschichtet.

Die für die elektrochemischen Korrosionstests vorgesehenen Körper wurden an einer konventionellen 3-Elektroden-Zelle geprüft. Das elektrische Potential der Arbeitselektrode wurde mittels einer gesättigten Calomel-Elektrode (SCE) über eine Brückenschaltung gemessen. Die Gegenelektrode war eine Graphitelektrode. Ein Computer-unterstützter Potentiostat (EG & GPAR 273 A) wurde benützt, um die Potentiale anzulegen, durchzusweepen und um das Ergebnis in Form von Potential/Stromkurven wiederzugeben.

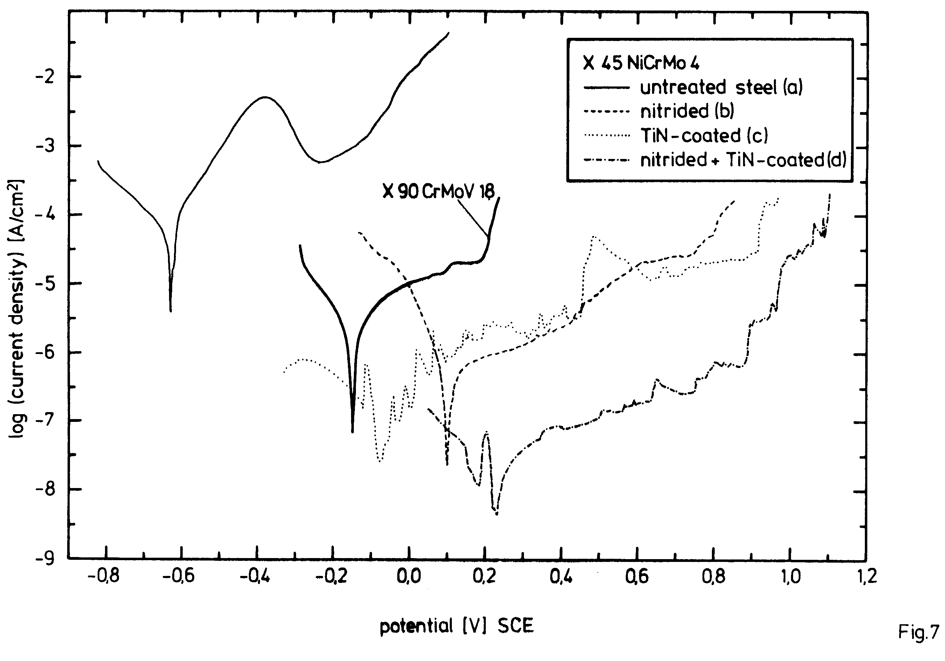

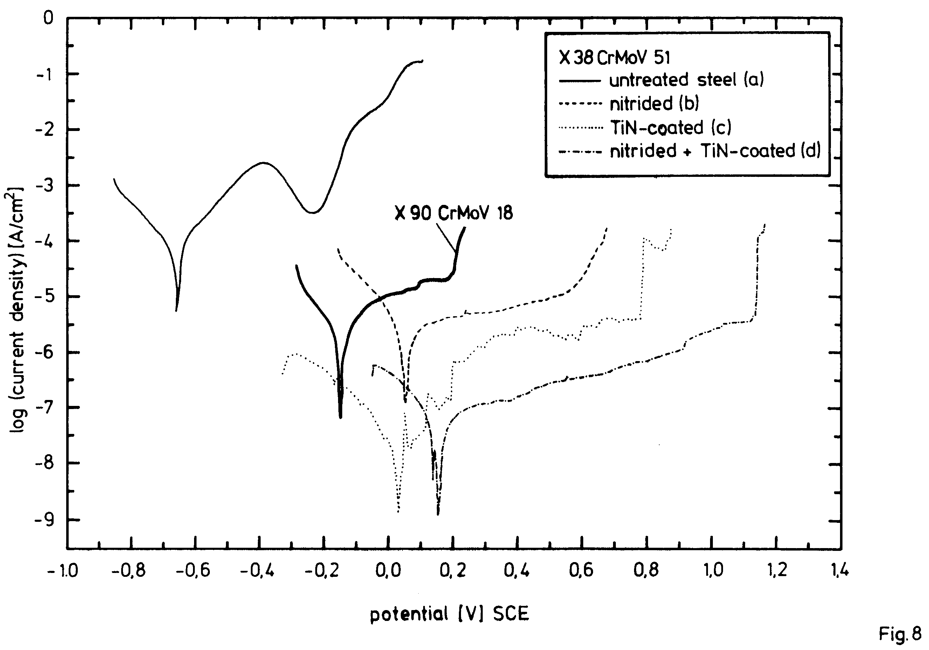

Die Resultate der potentiostatischen Messungen an unbeschichteten, nur nitrierten und nitriert- sowie hartstoffbeschichteten Körpern aus Baustahl bzw. Warmarbeitsstahl sind in den Fig. 7 bzw. 8 dargestellt.

Die potentiostatischen Messungen zeigen, dass überraschenderweise alle korrosionsrelevanten Grössen gegenüber rostfreiem Stahl signifikant verbessert werden.

Der anodische Zweig bricht bei allen Werkstoffen bei einem gewissen Potentialwert zu höheren Stromstärken aus. Werden Teile längere Zeit auf diesem elektrochemischen Potential gehalten, findet eine fortschreitende Zerstörung durch Auflösung, die meist als Lochfrass erscheint, auf. Dieses Potential wird daher Lochfrasspotential genannt. Die Aequivalenz von potentiostatischen Messungen und Korrosionsangriff im Einsatz besteht darin, dass es für die Vorgänge gleichwertig ist, ob die anodische Komponente des elektrochemischen Potentials elektrischen (potentiostat) oder chemischen (hohe Konzentration aggressiver Ionen) Ursprungs ist. Verbundwerkstoffe mit einem sehr stark anodischen Lochfrasspotential werden als edel bezeichnet. Die beiden Bilder zeigen, dass der erfindungsgemässe Verbundwerkstoff sehr viel edler ist als rostfreier Stahl. In der Praxis spielt natürlich die Kinetik eine ebenso wichtige Rolle. Es interessiert auch, wie sich der Werkstoff in weniger aggressiven Medien verhält. Dies wird elektrochemisch quantitativ als die Stromdichte bei Potentialen unterhalb des Lochfrasspotentials erfasst. Je niedriger diese Stromdichte (man beachte die logarithmische Skala) im anodischen Zweig ist, desto korrosionsfester ist ein Werkstoff. Die beiden Bilder zeigen eindrücklich nicht nur die Fortschritte gegenüber rostfreiem Stahl, sondern auch die Synergie der erfindungsgemässen Behandlung. Diese führt auch zu einem um Grössenordnungen korrosionsfesteren Werkstoff als Nitrieren oder Beschichten für sich alleine.

In Tabelle 4 sind die Resultate der Salzspraytests dargestellt.

Dabei wurde die Auswertung durch Beurteilung der einzelnen Körper nach dem Test entsprechend DIN 50021 ausgeführt. Die Bewertung '1' entspricht "keine sichtbare Korrosionsspuren" und '5' "starke Korrosion".

**Tabelle 4**

| Resultate der Salzspraytests | | | | |
|---|---|---|---|---|
| Stahlart | (A) Baustahl X45NiCrMo4 | (B) rostfrei X42CrNiMoV14 | (C) rostfrei X90CrMoV18 | (D) warmarb. X38CrMoV5 |
| unbehandelt | 5 | 3 | 3 | 5 |
| nitriert | 2 | 3 | 3 | 3 |
| Titaniumnitridbeschichtet | 4 | 4 | 4 | 4 |
| duplexbehandelt | 1 | 2 | 2 | 2 |

Die Beurteilung wird im Lichtmikroskop vorgenommen.

Es ergibt sich ein eindeutiges Bild: Vollkommen überraschend zeigt der erfindungsgemäss behandelte Baustahl (also das billigste Grundmaterial) das beste Verhalten von allen Werkstoffen und Verbundwerkstoffen. Nicht nur übertrifft er, wie der erfindungsgemäss behandelte Warmarbeitsstahl, den unbeschichteten rostfreien Stahl; es gibt auch keine Möglichkeit, die rostfreien Stähle so zu behandeln, dass sie an diese Leistung herankommen.

Prüfkörperlose (Zylinder mit geschliffener Stirnfläche) aus den verschiedenen Stählen wurden nitriert, beschichtet oder der erfindungsgemässen Doppelbehandlung unterzogen. Danach wurden sie folgendem Verschleisstest ausgesetzt: Die Stifte wurden in einen Schleifapparat mit Siliziumkarbidschleifpapier eingespannt und mit einer Geschwindigkeit von 200 Umdrehungen/Minute abgeschliffen. Nach 12 Minuten wurde der Gewichtsverlust bestimmt. Die Resultate sind in der folgenden Tabelle zusammengestellt.

| Prüfkörper | Gewichtsverlust in mg |
|---|---|
| X5CrNi18 10 | 320 |
| X90CrMoV18 gehärtet | 62 |
| X45NiCrMo4 gehärtet | 36 |
| X38CrMoV5 gehärtet | 42 |
| X90CrMoV18 gehärtet und mit 3µm Titannitrid beschichtet | 3.2 |
| X45NiCrMo4 gehärtet und mit 3µm Titannitrid beschichtet | 4.5 |
| X38CrMoV5 gehärtet und mit 3µm Titannitrid beschichtet | 2.6 |
| X90CrMoV18 gehärtet, thermochemisch vergütet mit 10µm Verbindungsschicht | 34 |
| X45NiCrMo4 gehärtet, thermochemisch vergütet mit 10µm Verbindungsschicht vom Typ ε, nämlich Fe₂₋₃N | 26 |
| X38CrMoV5 gehärtet, thermochemisch vergütet mit 10µm Verbindungsschicht vom Typ ε, nämlich Fe₂₋₃N | 31 |
| X90CrMoV18 gehärtet, thermochemisch vergütet mit 10µm Verbindungsschicht und mit 3µm Titannitrid beschichtet | 1.1 |
| X45NiCrMo4 gehärtet, thermochemisch vergütet mit 10µm Verbindungsschicht vom Typ ε, nämlich Fe₂₋₃N, und mit 3µm Titannitrid beschichtet | 0.9 |
| X38CrMoV5 gehärtet, thermochemisch vergütet mit 10µm Verbindungsschicht vom Typ ε, nämlich Fe₂₋₃N, und mit 3µm Titannitrid beschichtet | 0.5 |

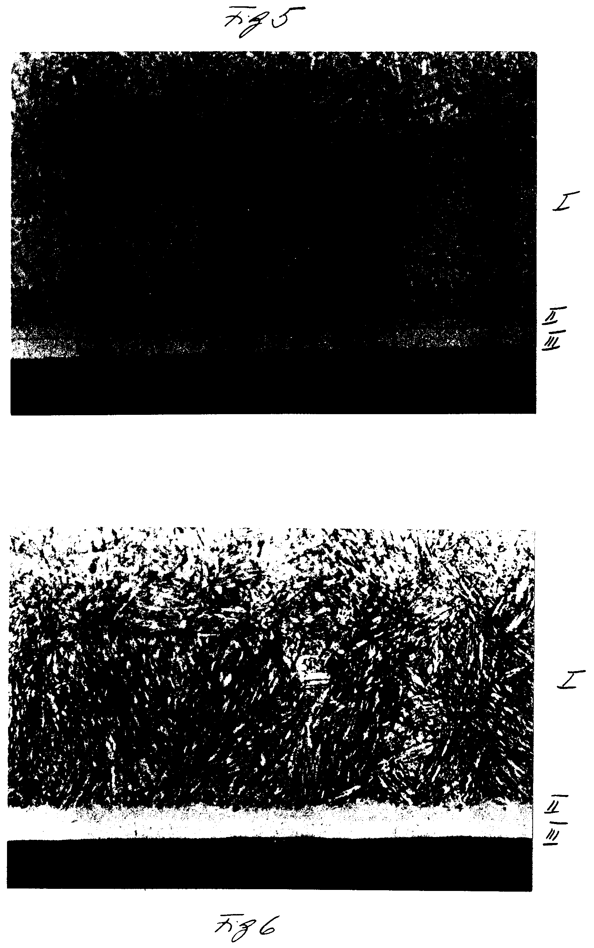

In Fig. 5 ist in tausendfacher Vergrösserung das Schliffbild des erfindungsgemäss behandelten Körpers aus X45NiCrMo4, in Fig. 6 bei gleicher Vergrösserung dasjenige eines Körpers aus dem Stahl X38CrMoV51 dargestellt. Die Zone I stellt das Stahlgefüge dar, die Zone II die thermochemische Vergütungsschicht und III die Hartstoffschicht, im vorliegenden Fall mit Titan, was aus der Gelbfärbung der Hartstoffschicht erkenntlich ist.

Im folgenden werden weitere Realisationsmöglichkeiten des vorliegenden erfindungsgemässen Verfahrens bzw. des erfindungsgemässen beschichteten Körpers dargestellt.

### 1. Erzeugung der Vergütungsschicht

Nebst durch Nitrieren, kann die Vergütungsschicht durch Borieren, Karborieren, Nitrokarborieren, Karbonitrieren, Oxinitrieren, Oxikarbonitrieren, Oxinitrokarborieren erzeugt werden, wird aber vorzugsweise durch Nitrieren des Stahlkörpers erzeugt, derart, dass die erwähnte Fe₂₋₃N- bzw. Fe₂₋₃(CN)-Verbindung entsteht.

In den Schliffbildern gemäss den Fig. 5 bzw. 6 sind scharfe Grenzen zwischen den Zonen III, der Hartstoffschicht, und II, der Vergütungsschicht, erkenntlich, insbesondere durch eine ausgesprochene Gelbfärbung der Hartstoffschicht, scharf übergehend in die weissere Vergütungsschicht.

Daran ist erkenntlich, dass durch das beschriebene Verfahren ein Absinken des N-Anteils in der Vergütungsschicht gegen die Grenzfläche zur Hartstoffschicht hin vermieden wurde. Zur Unterstützung dieses wesentlichen Konzentrationsverlaufes des in der Vergütungsschicht eingebauten, mindestens einen Elementes, insbesondere bei Einsatz anderer als des erwähnten Stickstoffes, wird, wie nachfolgend beschrieben, ein spezieller Prozessschritt eingeschaltet, um eine gegebenenfalls bei Aufbringen der Hartstoffschicht bewirkte Abnahme der erwähnten Elementenkonzentration im Uebergangsbereich zwischen Vergütungsschicht und Hartstoffschicht aufzufangen.

### 2. Zwischenschritte zwischen Vergüten und Aufbringen der Hartstoffschicht

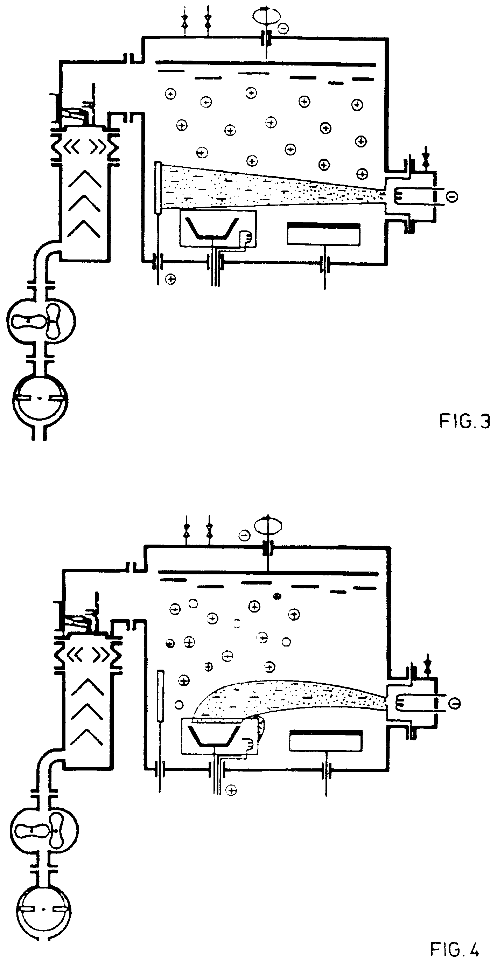

Nach Aufbringen der thermochemischen Vergütungsschicht und vor Aufbringen der Hartstoffschicht wird dazu ein Plasmaätzprozess, ebenfalls an derselben Anlage, eingesetzt durch Einsatz der Anlage gemäss Fig. 1 im Betrieb nach Fig. 3. Der Aetzprozess wird dabei so geführt, dass die Vergütungsschicht nach Aufbringen der Hartstoffbeschichtung keine Verarmung bezüglich dieser "Halbmetalle" aufweist, nämlich des mindestens einen Elementes C, N, B, O, S, Si. Verarmt die Vergütungsschicht beim Aufbringen der Hartstoffschicht an den genannten "Halbmetallen", so wird dadurch die Zug- und Scherfestigkeit der aufgebrachten Hartstoffschicht verringert. Die Hartstoffschicht wird bei Vorliegen einer solchen Verarmung entweder während des Einsatzes abgeschert, oder sie platzt aufgrund der an ihr üblicherweise vorhandenen Druckeigenspannungen ab.

Indem man mithin den Aetzprozess so führt, dass eine möglicherweise bei Hartstoffbeschichtung eintretende Verarmung an diesen "Halbmetallen" kompensiert wird, wird das Entstehen der erwähnten Verarmungszonen verhindert. Der in situ-Aetzprozess wird reaktiv durchgeführt. Dadurch kann die erwähnte "Halbmetall"-Konzentration an der geätzten Vergütungsschicht-Oberfläche beispielsweise erhöht werden, derart, dass bei nachmaliger Reduktion dieser Konzentration, nämlich bei Aufbringen der Hartstoffschicht, trotzdem keine Verarmungszonen entstehen.

### 3. Hartstoffbeschichtung

Die Hartstoffbeschichtung wird grundsätzlich mit einem reaktiven, plasmaunterstützten Verfahren aufgebracht, vorzugsweise mit einem PVD-Verfahren. Als Hartstoffschicht kann nebst der heute bevorzugten TiN-Schicht ein Borid, Nitrid, Karbid, Karbonitrid, Nitrokarbid, Oxinitrid, Oxikarbonitrid, Oxinitrokarbid, vorzugsweise eines Metalles der Gruppe IVb, oder einer Legierung mit mindestens einem dieser Metalle aufgebracht werden.

Auch vor dem Aufbringen der thermochemischen Vergütungsschicht kann ein Aetzschritt, z.B. H₂-Aetzen, vorgenommen werden, um die Gleichmässigkeit der folgenden Nitrierung zu erhöhen.

Es wurden an wie detailliert beschrieben beschichteten Körpern aus dem Stahl X45NiCrMo4, entsprechend 35NCD16, mit einer Vergütungsschicht mindestens überwiegend aus Fe₂₋₃N bzw. Fe₂₋₃(CN), die Druckspannungen in der Vergütungsschicht ermittelt. Sie betrugen ungefähr 860Mpa gegenüber Werten von ca. 560Mpa bei diesen Grundkörpermaterialien mit Vergütungs- und Hartstoffschicht vorbekannter Art, beispielsweise gemäss der EP-A-0 537 062.

Anfressen unter dynamischen Reibbedingungen erfolgte an, wie beschrieben, mit der Fe₂₋₃N- bzw. Fe₂₋₃(CN)-Vergütungsschicht versehenen Grundkörpern aus 34CrMo4, entsprechend dem Stahl 35CD4, erst bei einem Druck von ca. 2000N, während bei konventionellen Grundkörpern mit Nitrierungsvergütungsschicht und Hartstoffschicht aus dem gleichen Stahl Anfressen bereits bei 1400N einsetzte. Dabei war am erfindungsgemässen Grundkörper die Diffusionszone der Vergütungsschicht in das Grundkörpermaterial ca. 0,2mm tief, während die Fe₂₋₃N-Schicht gegen die Hartstoffschicht hin 8µm dick war.

Während bei konventionellen Vergütungsschicht-Nitrierungsprozessen eine Stickstoffatmosphäre mit lediglich 20 bis 22at% Stickstoff eingesetzt wird, wird erfindungsgemäss die Vergütungsschicht mit einem höheren Stickstoffanteil in der Prozessatmosphäre, nämlich von 25 bis 30at%, hergestellt. Die obgenannten Messungen bezüglich Spannungen und Anfressverhalten wurden durchgeführt im CETIM, Technical Centre for Mechanical Industry, F-60304 SENLIS.

## Patentansprüche

1. Korrosions- und verschleissfester Körper mit einem Grundkörper aus einem Warmarbeits- oder einem Baustahl, der mit einer thermochemischen Vergütungsschicht sowie einer Hartstoffschicht veredelt ist, dadurch gekennzeichnet, dass die Vergütungsschicht mindestens eines der Elemente C, N, B, O, S, Si umfasst, und dessen Anteil in Richtung aus dem Grundkörper gegen die Hartstoffschicht hin, bis hin zur Grenzfläche zur Hartstoffschicht, nicht abnimmt.

2. Korrosions- und verschleissfester Körper nach dem Oberbegriff von Anspruch 1, dadurch gekennzeichnet, dass die thermochemische Vergütungsschicht mindestens zu einem überwiegenden Anteil aus einer ε-Verbindung von Fe besteht, insbesondere aus Fe₂₋₃N, gegebenenfalls aus Fe₂₋₃(CN).

3. Körper nach einem der Ansprüche 1 oder 2, dadurch gekennzeichnet, dass die Hartstoffschicht mindestens im wesentlichen aus einem Borid, Nitrid, Karbid, Karbonitrid, Nitrokarbid, Oxinitrid, Oxikarbonitrid, Oxinitrokarbid, vorzugsweise eines Metalles der Gruppe IVb, oder einer Legierung mit mindestens einem dieser Metalle besteht, vorzugsweise im wesentlichen aus TiN.

4. Verfahren zur Herstellung eines korrosions- und verschleissfesten Körpers aus einem Bau- oder Warmarbeitsstahl, bei dem der Körper erst thermochemisch vergütet wird und darnach hartstoffbeschichtet, dadurch gekennzeichnet, dass als Vergütungsschicht eine Schicht mindestens überwiegend aus Fe₂₋₃N oder Fe₂₋₃(CN) erstellt wird.

5. Verfahren nach dem Oberbegriff von Anspruch 4, dadurch gekennzeichnet, dass die Vergütungsschicht mit Einbau mindestens eines der Elemente C, N, B, O, S, Si erfolgt und dessen Konzentrationsprofil so ausgelegt wird, dass es bei Aufbringen der Hartstoffschicht in der Vergütungsschicht nicht abnimmt.

6. Verfahren nach einem der Ansprüche 4 oder 5, dadurch gekennzeichnet, dass vor dem thermochemischen Vergüten in der Vakuumbehandlungskammer der Grundkörper plasmageätzt und/oder -geheizt wird.

7. Verfahren nach einem der Ansprüche 4 bis 6, dadurch gekennzeichnet, dass nach dem Aufbringen der thermochemischen Vergütungsschicht ein reaktiver, plasmaunterstützter Aetzschritt vorgenommen wird, während welchem die Zusammensetzung, insbesondere der Verlauf der Zusammensetzung, der Vergütungsschicht gesteuert wird, insbesondere der Verlauf der Konzentration eines der Elemente C, N, B, O, S, Si.

8. Verfahren nach einem der Ansprüche 4 bis 7, dadurch gekennzeichnet, dass die Hartstoffbeschichtung mittels eines PVD- oder PECVD-Verfahrens in der Vakuumbehandlungskammer erfolgt, vorzugsweise durch Ionenplattieren.

9. Verfahren nach einem der Ansprüche 4 bis 8, dadurch gekennzeichnet, dass der Grundkörper
a) in einer Reaktivgasatmosphäre thermochemisch vergütet wird, vorzugsweise in einer entladungsangeregten Reaktivgasatmosphäre, vorzugsweise dabei in einer mittels einer Niederspannungs-Bogenentladungs-angeregten Reaktivgasatmosphäre, worin vorzugsweise der Grundkörper auf anodisches Potential gelegt wird,
b) mittels eines PVD-Verfahrens mittels einer Feststoffquelle hartstoffbeschichtet wird, dabei vorzugsweise durch Ionenplattieren, wobei vorzugsweise der Feststoff von der Feststoffquelle mittels einer Niederspannungsentladung verdampft wird und der Grundkörper auf kathodisches Potential bezüglich des Feststoffes der Quelle gelegt wird.

10. Verfahren nach den Ansprüchen 5 und 7, dadurch gekennzeichnet, dass die Reaktivgasätzatmosphäre für die Herstellung der Vergütungsschicht mindestens eines der Elemente C, N, B, O, S, Si aufweist, vorzugsweise N, oder C und N, in überwiegendem Masse, und dass der Anteil desjenigen mindestens einen Elementes, welches überwiegend auch in der Vergütungsschicht-Herstell-Reaktivgasatmosphäre vorherrschte, in der Aetz-Reaktivgasatmosphäre so geführt wird, dass er im Bereich der geätzten Vergütungsschicht-Oberfläche eine Abnahme dieses Elementes bei Aufbringen der Hartstoffschicht mindestens kompensiert.

11. Verfahren nach einem der Ansprüche 4 bis 10, dadurch gekennzeichnet, dass der Grundkörper vor und/oder nach dem Aufbringen der Vergütungsschicht thermisch behandelt wird, vorzugsweise durch Elektronenbeschuss.

12. Verfahren nach einem der Ansprüche 4 bis 11, dadurch gekennzeichnet, dass mindestens für zwei der Schritte
- thermisches Behandeln,
- Herstellen der Vergütungsschicht,
- Aetzen,
- Aufbringen der Hartstoffschicht,
dieselbe Entladungskathode an der Vakuumkammer eingesetzt wird, vorzugsweise dieselbe elektronenemittierende Heisskathode.

13. Vakuumbehandlungsanlage zur Herstellung eines korrosions- und verschleissfesten Körpers nach einem der Ansprüche 1 bis 3, dadurch gekennzeichnet, dass sie umfasst
- eine Entladungskathode,
- einen Substratträger zur Aufnahme des Grundkörpers,
- eine Feststoffquelle,
- einen mit einem Gastank verbundenen Gaseinlass mit Gasfluss-Stellglied und verbunden mit einem Gastank, der mindestens eines der Elemente C, N, O, B, S, Si enthält,
dass weiter der Substratträger umschaltbar bezüglich der Entladungskathode auf anodisches Potential legbar ist, ebenso die Feststoffquelle, um die Entladung einerseits von der Kathode auf den Substratträger oder die Feststoffquelle anderseits umzuschalten, und dass weiter der Substratträger umschaltbar bezüglich der Feststoffquelle auf kathodisches Potential legbar ist.

14. Anlage nach Anspruch 13, dadurch gekennzeichnet, dass in der Kammer eine Hilfsanode vorgesehen ist, um die Entladung zwischen der Kathode und letzterer zu erzeugen.

15. Anlage nach einem der Ansprüche 13 oder 14, dadurch gekennzeichnet, dass die Entladungskathode eine elektronenemittierende Heisskathode ist.
